# EUROPÄISCHE PATENTSCHRIFT

(11) **EP 1 774 352 B1**
(45) Veröffentlichungstag und Bekanntmachung des Hinweises auf die Patenterteilung: **28.11.2007**
(21) Anmeldenummer: 05768102.5
(22) Anmeldetag: 07.07.2005
(51) Int. Cl.: G01R 31/36

(54) **FAHRZEUGBATTERIEANORDNUNG MIT ELEKTRONIKKOMPONENTEN**
VEHICLE BATTERY ARRANGEMENT COMPRISING ELECTRONIC COMPONENTS
SYSTEME DE BATTERIE AUTOMOBILE COMPORTANT DES COMPOSANTS ELECTRONIQUES

(30) Priorität: 07.07.2004 DE 102004032947
(43) Veröffentlichungstag der Anmeldung: 18.04.2007
(73) Patentinhaber: IQ Power Licensing AG, 6300 Zug (CH)
(72) Erfinder: BAUER, Günther, 8551 Ottobrunn (DE); RICKERT, Winfried, 85622 Feldkirchen (DE)
(74) Vertreter: Müller, Thomas
(86) Internationale Anmeldenummer: PCT/DE2005/001191
(87) Internationale Veröffentlichungsnummer: WO 2006/005313

(56) Entgegenhaltungen:
- EP-A- 1 132 990
- WO-A-03/049211
- DE-A1- 4 422 005
- DE-A1- 10 056 972
- DE-A1- 19 823 916
- DE-A1- 19 834 740
- GB-A- 2 222 494
- US-A- 5 599 636
- US-A1- 2003 047 366

## Beschreibung

Die Erfindung betrifft eine Fahrzeugbatterieanordnung, die mit Sensoren und einer Sensorelektronik ausgestattet ist, mit deren Hilfe die Batterie auf ihren Lade- und Betriebszustand überwacht wird.

Aus dem Stand der Technik sind Batterien mit derartigen Anordnungen bekannt. Da die zu ermittelnden Meßgrößen auch von Störgrößen überlagert werden, was zu Meßwertverfälschungen führt, müssen die Sensoren und die Sensorelektronik so ausgebildet sein, daß die Meßwertverfälschungen, d. h. die Meßfehler unter einer vorgegebenen Größe bleiben. Dazu sind aus dem Stand der Technik, speziell der Sensortechnik, verschiedene Maßnahmen zur Meßfehler-Korrektur bekannt.

So wird z. B. in der DE 100 56 972 A1 vorgeschlagen, eine Einrichtung zur Batteriezustandserkennung innerhalb der Batterie anzuordnen, damit möglichst kurze Leitungsverbindungen zwischen den einzelnen Komponenten möglich sind. Bei dieser Einrichtung sind ein Temperatursensor zur Bestimmung der Batterieinnentemperatur und ein Dichtesensor zur Bestimmung der Elektrolytdichte innerhalb einer Batteriezelle angeordnet. Die dazugehörige Elektronik ist unmittelbar über den Batteriezellen und innerhalb des Batteriegehäuses angeordnet. Diese Einrichtung zur Batteriezustandserkennung hat jedoch den Nachteil, daß die relativ teuren Bauelemente der Batteriezustandserkennungsvorrichtung bei der Verschrottung der Batterie in dieser verbleiben, so daß die Batteriekosten dadurch insgesamt unakzeptabel hoch werden.

Es besteht somit die Aufgabe der Erfindung, eine Fahrzeugbatterieanordnung mit einer Batteriezustandserkennungsvorrichtung bereitzustellen, die einerseits eine genaue Erfassung und Auswertung der Sensordaten, andererseits jedoch auch eine kostengünstige Fertigung der Fahrzeugbatterieanordnung ermöglicht.

Diese Aufgabe der Erfindung wird mit einer Fahrzeugbatterieanordnung nach Anspruch 1 gelöst.

Die erfindungsgemäße Fahrzeugbatterieanordnung weist eine Fahrzeugbatterie auf, die von einem Wärmeisolationskasten umschlossen ist. Der Wärmeisolationskasten hat einen abnehmbaren Deckel. Weiterhin ist eine Batteriezustandserkennungsvorrichtung vorgesehen, die aus mehreren elektronischen Bauelementen und Komponenten besteht, so aus wenigstens einem Sensor zur Erfassung wenigstens einer batteriespezifischen Meßgröße, wie z. B. der Batteriespannung, des Batteriestroms, der Batterietemperatur oder der Elektrolytdichte. Weiterhin sind Meßsignalumwandlungsschaltungen und Speicher- und Rechenschaltungen vorgesehen.

Diese elektronischen Bauelemente und Komponenten sind in zwei voneinander räumlich getrennte Module aufgeteilt, wobei die Aufteilung nach folgendem Prinzip vorgenommen wird:

In oder an der Batterie, d. h. im Batteriemodul, werden die elektronischen Bauelemente und Komponenten angeordnet, die bezüglich ihrer Funktionalität und ihrer Aufgabe nur dort angeordnet sein können. So ist es z. B. immer erforderlich, daß ein Sensor zur Messung der Elektrolytdichte in den Elektrolyten eintaucht, wenn das Meßprinzip das Eintauchen voraussetzt. Wenn es erforderlich ist, daß innerhalb der Batterie gewonnenen Sensordaten zwischengespeichert werden müssen und diese Daten zumindest teilweise bei der Batterie verbleiben sollen, ebenso wie z. B. eine elektronische Kennummer, dann ist es erforderlich, daß bei der Batterie auch ein Speicherbauelement verbleibt, in dem die Sensordaten und die Kennummer gespeichert sind.

Alle anderen elektronischen Bauelemente und Komponenten werden in einem Deckelmodul zusammengefaßt und auf der Innenseite des Deckels des Wärmeisolationskastens angeordnet, wobei eine nahe Lagebeziehung zwischen Batteriemodul und Deckelmodul zu kurzen Leitungswegen führt.

Der Vorteil der Erfindung gegenüber dem Stand der Technik ist der Umstand, daß mit der vorliegenden Anordnung zwischen den Komponenten ebenfalls sehr kurze Leitungswege erzielt werden können und bei einer Verschrottung der Batterie jedoch nur die elektronischen Bauelemente und Komponenten des Batteriemoduls verloren sind. Die elektronischen Bauelemente und Komponenten des Deckelmoduls bleiben in dem Deckel des Isolationskastens, der als Bestandteil des Fahrzeugs bei diesem verbleibt, d. h. der Deckel wird nicht verschrottet. Daraus ergibt sich gegenüber dem Stand der Technik ein beträchtlicher Kostenvorteil.

Ein aus DE 198 34 740 A1 bekannter Vorteil liegt darin, daß in innerhalb der Batterie nahezu keine von außen bewirkte Temperaturgradienten auftreten können, da Temperaturschwankungen von außen durch das wärmeisolierende Gehäuse nur sehr langsam in die Batterie vordringen. Die dabei entstehenden positiven Effekte werden nachfolgend erläutert:

Sensoren sind nahezu immer temperaturabhängig, d. h. das Temperaturänderungen den eigentlichen Meßwert verfälschen. Ebenso sind die elektronischen Verstärkerschaltungen, die unmittelbar nach dem Sensor angeordnet sind, ebenfalls temperaturabhängig. Daher sind im Bereich der Meßtechnik seit vielen Jahrzehnten spezielle Schaltungen zur Temperaturkompensation entwickelt worden, wobei unter Temperaturkompensation meist eine sogenannte statische Kompensation verstanden wird, d. h. wenn die Temperatur in der Umgebung des Sensors oder der Auswerteelektronik einen vorbestimmten Wert aufweist, der sich nicht oder nur sehr langsam ändert. Mit anderen Worten arbeitet die Temperaturkompensation dann optimal, wenn im Bereich des Sensors und/oder im Bereich der Auswerteelektronik, vorzugsweise der ersten Stufe der Auswerteelektronik, keine Temperaturausgleichsvorgänge, d. h. keine Temperaturgradienten auftreten.

Relativ schwer beherrschbar sind Meßfehler, die dann entstehen, wenn Temperaturausgleichsvorgänge stattfinden. So kann z. B. die Temperatur am Sensor oder an der Auswerteelektronik eine andere sein als an der Stelle, an der die Temperatur gemessen wird, um sie als Korrekturwert für die Temperaturkompensation zu gewinnen. In diesem Fall ist demzufolge die Temperaturkompensation des Meßwertes z. T. stark fehlerhaft.

Da der Wärmeisolationskasten jedoch verhindert, daß durch äußere Temperatureinflüsse unzulässig große Temperaturgradienten entstehen, kann eine genaue Bestimmung der eigentlichen Meßgröße erfolgen und/oder an die Auswerteelektronik werden nur geringere Anforderungen bezüglich der Temperaturempfindlichkeit gestellt. Das wiederum hat den Vorteil, daß die Elektronik preiswert gefertigt werden kann, was besonders bei Massenprodukten wie Fahrzeugbatterien gefordert wird.

Obwohl die vorstehend beschriebenen Wirkungen von meßwertverfälschenden Temperatureinflüssen erläutert worden sind unter der Voraussetzung, daß die Meßgröße eine andere physikalischen Größe ist als die Temperatur, ist dem Fachmann klar, daß auch bei Temperaturmessungen temperaturbedingte Fehler auftreten können, wenn z. B. zwischen dem Temperatursensor und der Auswerteelektronik ein räumlich und/zeitlicher Temperaturgradient anliegt.

Nach Anspruch 2 ist in der Fahrzeugbatterie eine Flüssigelektrolytdurchmischungsvorrichtung vorgesehen, so daß durch die Durchmischung des Flüssigelektrolyten eine schnellere Angleichung der Innentemperatur des Wärmeisolationskastens erfolgt. Diese Weiterbildung der Erfindung hat dann einen besonderen Vorteil, wenn die Fahrzeugbatterie mit einer aus dem Stand der Technik bekannten Batterieheizung ausgestattet ist.

Eine derartige Heizung wird zur Erwärmung des Flüssigelektrolyten eingesetzt. Aus dem Stand der Technik ist bekannt, Batterien bei niedrigen Außentemperaturen, wie z. B. im Winter, mittels einer z. B. an dem Batteriegehäuse angeordneten Widerstandsheizung zu erwärmen, wodurch u. a. die Fähigkeit zur Stromaufnahme und zur Stromabgabe wesentlich verbessert wird. Eine derartige Heizung erzeugt innerhalb des Batteriegehäuses vorstehend besprochene und unerwünschte Temperaturgradienten, die empfindliche Messungen von Batteriemeßgrößen stören können. Durch die Umwälzung des flüssigen Elektrolyten erfolgt eine hocheffiziente Temperaturverteilung und somit eine Minimierung der durch die Heizung entstehenden unerwünschten Temperaturgradienten. Mit anderen Worten liegt bei der vorliegenden Weiterbildung der Erfindung der Vorteil darin begründet, daß neben der Elektrolytumwälzung ein sehr schneller Wärmeausgleich erfolgt.

Nach Anspruch 3 wird zur Elektrolytdurchmischung eine Vorrichtung eingesetzt, die die Bewegungen des Fahrzeugs dazu nutzt, den flüssigen Elektrolyten in dem Batteriekasten umzuwälzen. Solche Vorrichtungen sind aus dem Stand der Technik an sich bekannt und weisen Einbauten auf, die den Elektrolyt in eine vorbestimmte Strömungsbahn zwingen, so daß eine gute Durchmischung erfolgt. Der Vorteil dieser Weiterbildung der Erfindung besteht darin, daß die Durchmischungsvorrichtung einfach und kostengünstig ist und daß die Durchmischung selbsttätig erfolgt.

Nach Anspruch 4 sind in dem Deckel Kontaktpole vorgesehen, die zu den Kontaktpolen der Fahrzeugbatterie passen und die an der Deckelaußenseite zugänglich sind, wobei die Kontaktpole so ausgebildet sind, daß beim Aufsetzen des Deckels auf den Wärmeisolationskasten eine mechanisch und elektrisch stabile und ausreichend dimensionierte Verbindung entsteht. Diese Ausführungsform ist besonders vorteilhaft, da der Deckel keine zusätzliche aufwendige Halterung benötigt, so daß die Gesamtkosten verringert werden können.

Nach Anspruch 5 ist das Batteriemodul mit dem Deckelmodul über eine Power-line-Datenkommunikation verbunden, die über die Batteriekontaktpole verläuft. Diese beste Ausführungsform der Erfindung ermöglicht den Verzicht auf eine zusätzliche Verdrahtung zwischen dem Deckelmodul und dem Batteriemodul.

Die Erfindung wird nachfolgend an Hand eines Ausführungsbeispiels in Verbindung mit schematischen Zeichnungen näher erläutert.
- Fig. 1 zeigt: eine schematische Seitenansicht der Erfindung als Schnittdarstellung.

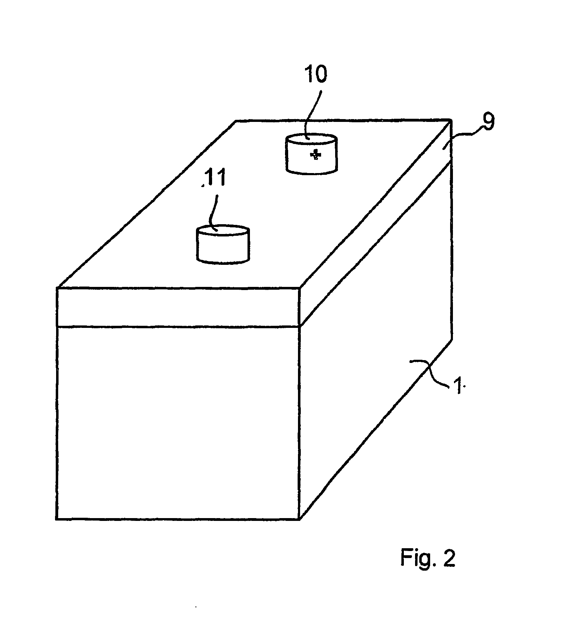

- Fig. 2 zeigt: eine perspektivische Gesamtansicht.

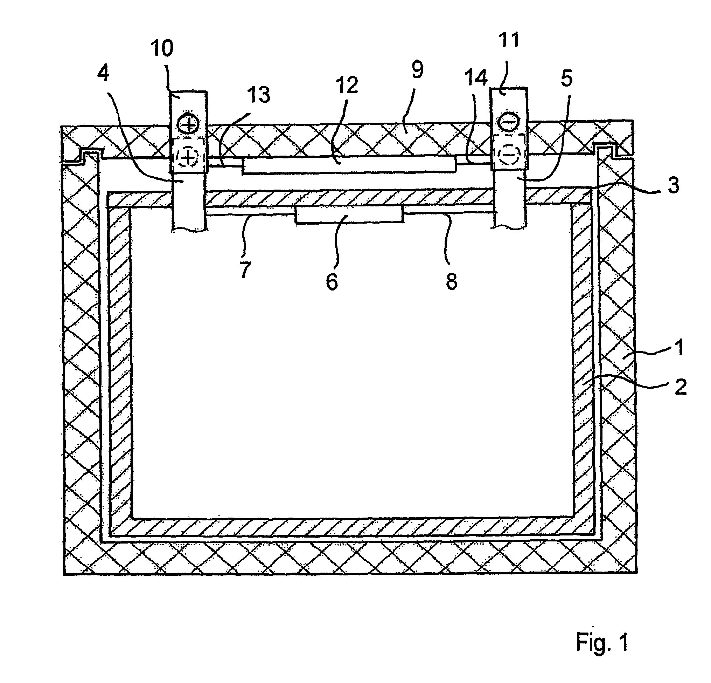

Fig. 1 zeigt einen Wärmeisolationskasten 1, der aus einem Kunststoffschaum mit einem hohen Wärmeisolationsvermögen besteht. In dem Wärmeisolationskasten 1 steht eine Blei-Säure-Batterie mit einem Gehäuse 2, einer Abdeckung 3 und mit zwei Kontaktpolen 4 und 5. An der Außenseite des Gehäuses 2 ist eine Widerstandheizung (nicht gezeigt) zur Erwärmung der Batterie vorgesehen. In dem Gehäuses 2 sind weiterhin Durchmischungseinbauten (nicht gezeigt) vorgesehen, die dafür sorgen, daß bei Bewegungen der Batterie, wie sie typischerweise bei Beschleunigungs- und Bremsvorgängen in einem Kraftfahrzeug entstehen, die Batteriesäure gut durchmischt wird.

Unterhalb der Abdeckung 3 ist das Batteriemodul 6 angeordnet, das einen Temperatursensor aufweist, eine erste Auswerteelektronik und wenigsten einen Datenspeicher, um wenigstens eine Kennummer und einen Satz Sensordaten der Batterie zu speichern. Die Kennummer dient zur Identifizierung der Batterie und der Satz Sensordaten enthält Daten über den Betriebszustand der Batterie, wobei unter dem Betriebszustand eine Kenngröße verstanden wird, die den Lade- und Verschleißzustand der Batterie bezeichnet. Das Batteriemodul 6 bezieht seine Versorgungsspannung über die Batterie mittels der Leitungen 7, 8.

Auf dem Wärmeisolationskasten 1 ist ein Deckel 9 angeordnet, der Polanschlüsse 10 und 11 aufweist, die zu den Polanschlüssen 4 und 5 der Batterie passen und die so ineinandergreifen, daß eine mechanisch und elektrisch ausreichend sichere Verbindung hergestellt ist. Unterhalb des Deckels 7 ist das Deckelmodul 12 angeordnet, das seine Versorgungsspannung mittels der Leitungen 13, 14 ebenfalls von der Batterie bezieht.

Der Datentransfer zwischen dem Batteriemodul 6 und der Deckelmodul 12 erfolgt über eine Powerline-Kommunikation, wie z. B. über einen CAN-BUS.

Es ist besonders zu erwähnen, daß der Satz Sensordaten, der den aktuellen und vergangenen Betriebszustand der Batterie abbildet, nicht notwendigerweise allein in dem Batteriemodul gemessen und errechnet werden muß, sondern vielmehr auch in dem Deckelmodul oder von einem anderen externen Modul, wie z. B. vom Bordcomputer des Fahrzeugs und von dort aus über die Powerline wieder an das Batteriemodul zurück geschickt werden kann.

## Patentansprüche

1. Fahrzeugbatterieanordnung mit einer Batteriepolanschlüsse (**4, 5**) aufweisenden Fahrzeugbatterie mit einer Batteriezustandserkennungsvorrichtung, wobei
die Fahrzeugbatterie von
- einem Wärmeisolationskasten (**1**) umschlossen ist, und
- die Batteriezustandserkennungsvorrichtung wenigstens
- einen Sensor,
- eine Signalumwandlungsschaltung,
- eine erste Signalverarbeitungsschaltung und
- wenigstens eine weitere Signalverarbeitungsschaltung aufweist, wobei
- in der ersten Signalverarbeitungsschaltung wenigstens ein elektronischer Datenspeicher vorgesehen ist, wobei
- die ersten Signalverarbeitungsschaltung zu einem Batteriemodul (**6**) zusammengefaßt ist, das innerhalb oder außerhalb am Gehäuse (**2**) der Fahrzeugbatterie unlösbar befestigt ist
- **dadurch gekennzeichnet, daß** der Wärmeisolationskasten einen Deckel (9) aufweist und die wenigstens eine weitere Signalverarbeitungsschaltung zu einem Deckelmodul (**12**) zusammengefaßt ist, das im Deckel (**9**) des Wärmeisolationskastens (1) angeordnet ist.

2. Fahrzeugbatterieanordnung nach Anspruch 1, **dadurch gekennzeichnet, daß** die Fahrzeugbatterie eine Flüssigelektroytbatterie ist, in der eine Flüssigelektrolytdurchmischungsvorrichtung vorgesehen ist.

3. Fahrzeugbatterieanordnung nach Anspruch 2, **dadurch gekennzeichnet, daß** die Flüssigelektrolytdurchmischungsvorrichtung nach dem Prinzip der Elektrolytbewegung bei der Fahrzeugbeschleunigung arbeitet.

4. Fahrzeugbatterieanordnung nach Anspruch 1, **dadurch gekennzeichnet, daß** in dem Deckel **(9)** Kontaktpole **(10, 11)** vorgesehen sind, die zu den Kontaktpolen **(4, 5)** der Fahrzeugbatterie passen und die an der Deckelaußenseite zugänglich sind, wobei die Kontaktpole **(10,11)** so ausgebildet sind, daß beim Aufsetzen des Deckels **(9)** auf den Wärmeisolationskasten **(1)** eine mechanisch und elektrisch stabile und ausreichend dimensionierte Verbindung entsteht.

5. Fahrzeugbatterieanordnung nach Anspruch 4, **dadurch gekennzeichnet, daß** das Batteriemodul **(6)** mit dem Deckelmodul **(12)** über eine Powerline-Datenkommunikation verbunden ist, die über die Batteriekontaktpole **(4, 10; 5, 11)** verläuft.

## Claims

1. Vehicle battery arrangement including a vehicle battery provided with electric contacts **(4, 5)** and a device for monitoring the operating state of battery, wherein the vehicle battery is housed in a heat-insulating box **(1)** and
the device for monitoring the operating state of the battery comprises at least
- a sensor,
- a signal conversion circuit,
- a first signal processing circuit and
- at least another signal processing circuit, wherein
- at least one electronic data memory is arranged in the first signal processing circuit and wherein
- the first signal processing circuit is combined to a battery module **(6)** non-detachably mounted to an inside surface or an outside surface of the battery case **(2),**
**characterized in that**
- the heat-insulating box **(1)** comprises a cover **(9)** and at least another signal processing circuit is combined to a cover module **(12)** arranged in the cover **(9)** of the heat-insulating box **(1).**

2. Vehicle battery arrangement according to claim 1,
**characterized in that**
the vehicle battery is a liquid electrolyte type battery provided in the inside thereof with a device for intermixing the liquid electrolyte.

3. Vehicle battery arrangement according to claim 2,
**characterized in that**
the device for intermixing the liquid electrolyte works on the principle of electrolyte movement occurring when the vehicle is accelerated.

4. Vehicle battery arrangement according to claim 1,
**characterized in that**
the cover **(9)** is provided with electric contacts **(10, 11)** which match to the electric contacts **(4, 5)** of the vehicle battery and are accessible at the outside of the cover and are configured so that a sufficiently dimensioned mechanical and electrical connection is formed when the cover **(9)** is placed onto the heat-insulating box **(1).**

5. Vehicle battery arrangement according to claim 4,
**characterized in that**
the battery module **(6)** and the cover module **(12)** are interconnected via a power-line data communication which is routed via the electric contacts **(4, 10; 5, 11).**

## Revendications

1. Système de batterie de véhicule pourvue d'une batterie de véhicule comprenant des raccords de pôle de batterie (4, 5) et dotée d'un dispositif de détection d'état de la batterie,
la batterie de véhicule
- étant entourée par un caisson d'isolation thermique (1), et
- le dispositif de détection d'état de la batterie comprenant au moins
-- un capteur,
-- un circuit de conversion de signal,
-- un premier circuit de traitement de signal et
-- au moins un autre circuit de traitement de signal,
-- au moins une mémoire d'information électronique étant prévue dans le premier circuit de traitement de signal,
-- le premier circuit de traitement de signal étant coordonné à un module de batterie (6), qui est fixé de manière inamovible à l'intérieur ou à l'extérieur sur le logement (2) de la batterie de véhicule
-- **caractérisé en ce que** le caisson d'isolation thermique comprend un couvercle (9) et le au moins un autre circuit de traitement de signal est coordonné à un module de couvercle (12) qui est disposé dans le couvercle (9) du caisson d'isolation thermique (1).

2. Système de batterie de véhicule selon la revendication 1, **caractérisé en ce que** la batterie de véhicule est une batterie à électrolyte liquide dans laquelle est prévu un dispositif de mélange intime d'électrolyte liquide.

3. Système de batterie de véhicule selon la revendication 2, **caractérisé en ce que** le dispositif de mélange intime d'électrolyte liquide fonctionne selon le principe du déplacement d'électrolyte lorsque le véhicule accélère.

4. Système de batterie de véhicule selon la revendication 1, **caractérisé en ce que** des pôles de contact (10, 11) sont prévus dans le couvercle (9), lesquels s'adaptent aux pôles de contact (4, 5) de la batterie de véhicule et sont accessibles depuis le côté extérieur du couvercle, les pôles de contact (10, 11) étant conçus de sorte que lorsque le couvercle (9) est posé sur le caisson d'isolation thermique (1), cela crée une liaison mécaniquement et électriquement stable de dimension suffisante.

5. Système de batterie de véhicule selon la revendication 4, **caractérisé en ce que** le module de batterie (6) est relié au module de couvercle (12) par des courants porteurs de données en ligne, qui s'étend au-dessus des pôles de contact de batterie (4, 10 ; 5, 11).
